# EUROPEAN PATENT APPLICATION

(11) **EP 4 478 415 A1**
(43) Date of publication of application: **18.12.2024**
(21) Application number: 24150935.5
(22) Date of filing: 09.01.2024
(51) Int. Cl.: H01L 27/146

(54) **IMAGE SENSOR**

(30) Priority: 15.06.2023 KR 20230076848
(71) Applicant: Samsung Electronics Co., Ltd., Suwon-si, Gyeonggi-do 16677 (KR)
(72) Inventor: KIM, Youngrae, 16677 Suwon-si, Gyeonggi-do (KR); PARK, Sachoun, 16677 Suwon-si, Gyeonggi-do (KR); JUNG, Daeuk, 16677 Suwon-si, Gyeonggi-do (KR); CHO, Jeongjin, 16677 Suwon-si, Gyeonggi-do (KR); PYO, Junghyung, 16677 Suwon-si, Gyeonggi-do (KR)
(74) Representative: Kuhnen & Wacker Patent- und Rechtsanwaltsbüro PartG mbB

(57) **Abstract**

An image sensor (500) includes a first substrate (1) having a first side (1a) and a second side (1b) opposite each other, and including a pixel array region (APS) having plurality of active regions (ACT) disposed at the first side (1a), a shallow trench isolation structure (STI) disposed at the first side (1a) of the first substrate (1) and isolating each of the plurality of active regions (ACT), a plurality of floating diffusion regions (FD) disposed at the plurality of active regions of the first substrate (1), and a floating diffusion region connector (19) connecting the plurality of floating diffusion regions (FD) with each other. The floating diffusion region connector (19) is buried in the shallow trench isolation structure (STI) and an upper surface of the floating diffusion region connector (19) is lower than an upper surface of the shallow trench isolation structure (STI).

## Description

### BACKGROUND

### (a) Field

The present disclosure relates to an image sensor.

### (b) Description of the Related Art

An image sensor is a semiconductor device for converting optical images into electrical signals. The image sensor may be classified into a charge coupled device (CCD) type and a complementary metal oxide semiconductor (CMOS) type. The CMOS-type image sensor may be referred to as a CMOS image sensor (CIS). The CIS has pixels arranged in a two-dimensional way. Each of the pixels includes a plurality of photodiodes for converting incident light into an electric signal and a plurality of floating diffusion regions for temporarily storing the electric signal generated by the plurality of photodiodes' photoelectric conversion. Floating diffusion regions in each pixel may be connected to one source follower gate, and the electric signal may be output to an outside through the source follower gate.

### SUMMARY

An embodiment may provide an efficient connection structure between floating diffusion regions.

According to an embodiment of the present disclosure, an image sensor includes a first substrate having a first side and a second side opposite each other, and including a pixel array region having plurality of active regions disposed at the first side, a shallow trench isolation structure disposed at the first side of the first substrate and isolating each of the plurality of active regions, a plurality of floating diffusion regions disposed at the plurality of active regions of the first substrate, and a floating diffusion region connector connecting at least two of the plurality of floating diffusion regions with each other. At least a part of the floating diffusion region connector is buried in the shallow trench isolation structure and an upper surface of the floating diffusion region connector is lower than an upper surface of the shallow trench isolation structure.

According to an aspect of the present disclosure, an image sensor includes a first substrate having a first side and a second side opposite each other, and including a pixel array region including a plurality of sub-unit pixels and an edge region, an antireflection structure disposed on the second side, a pixel separator disposed on the first substrate and separating the plurality of sub-unit pixels from each other, a color filter disposed in the antireflection structure, a first interlayer insulating layer disposed on the first side of the first substrate, a first wire disposed in the first interlayer insulating layer, a second interlayer insulating layer disposed below the first interlayer insulating layer, a second wire disposed in the second interlayer insulating layer, and a second substrate disposed below the second interlayer insulating layer. The first substrate includes a shallow trench isolation structure disposed in the first substrate, extending from the first side toward the second side, and isolating a plurality of active regions formed at the first side, a plurality of floating diffusion regions disposed at the plurality of active regions of the first substrate, a floating diffusion region connector buried in the shallow trench isolation structure and connecting at least two of the plurality of floating diffusion regions with each other, and a cover insulating layer formed on an upper surface of the floating diffusion region connector and having a contact hole exposing the upper surface of the floating diffusion region connector. A portion of the first wire further corresponds to a source follower gate electrode of a source follower transistor. The source follower gate electrode is connected to the floating diffusion region connector through the contact hole.

According to an embodiment of the present disclosure, an image sensor includes a first substrate having a first side and a second side opposite each other, and including a pixel array region including a plurality of sub-unit pixels and an edge region, an antireflection structure disposed on the second side, a pixel separator disposed on the first substrate and separating the plurality of sub-unit pixels from each other, a color filter disposed in the antireflection structure, a first interlayer insulating layer disposed on the first side of the first substrate, a first wire disposed in the first interlayer insulating layer, a second substrate disposed below the first interlayer insulating layer, a second interlayer insulating layer disposed below the second substrate, a second wire disposed in the second interlayer insulating layer, a third interlayer insulating layer disposed below the second interlayer insulating layer, a third wire disposed in the third interlayer insulating layer, and a third substrate disposed below the third interlayer insulating layer. The first substrate includes a shallow trench isolation structure disposed at the first substrate, extending from the first side toward the second side, and isolating a plurality of active regions disposed at the first side, a plurality of floating diffusion regions disposed at the plurality of active regions of the first substrate, and a floating diffusion region connector buried in the shallow trench isolation structure and connecting at least two of the plurality of floating diffusion regions with each other. A portion of the second wire corresponds to a source follower gate electrode of a source follower transistor. The source follower gate electrode is connected to the floating diffusion region connector through a penetration via passing through the second substrate.

According to an embodiment, the coupling among the wires may be reduced by disposing the floating diffusion region connector for connecting between the floating diffusion regions in the shallow trench isolator.

According to an embodiment, the freedom of disposing wires may be increased by disposing the floating diffusion region connector for connecting between the floating diffusion regions in the shallow trench isolator.

### BRIEF DESCRIPTION OF THE DRAWINGS

FIG. 1 shows a block diagram of an image sensor according to an embodiment.
FIG. 2 shows a circuit diagram of an active pixel sensor array of an image sensor according to an embodiment.
FIG. 3 shows a top plan view of an image sensor according to an embodiment.
FIG. 4 shows a cross-sectional view taken along line A-A' of FIG. 3.
FIG. 5 shows an enlarged top plan view on disposition of a transmission gate, a floating diffusion region, a floating diffusion region connector, and a source follower gate in an image sensor according to an embodiment.
FIG. 6A shows a cross-sectional view taken along line A-A' of FIG. 5, corresponding to a region P1 of FIG. 4.
FIG. 6B shows a cross-sectional view taken along line B-B' of FIG. 5.
FIG. 6C shows a cross-sectional view taken along line C-C' of FIG. 5.
FIG. 7A to FIG. 7D show cross-sectional views showing a method for forming a floating diffusion region connector of an image sensor according to an embodiment.
FIG. 8A to FIG. 8D show cross-sectional views showing a method for forming a floating diffusion region connector of an image sensor according to an embodiment.
FIG. 9 shows a cross-sectional view of an image sensor according to an embodiment.

### DETAILED DESCRIPTION OF THE EMBODIMENTS

The embodiments will be described more fully hereinafter with reference to the accompanying drawings.

The drawings and the descriptions are to be considered as illustrative and not as restrictive. Throughout the specification, the same reference numbers indicate the same constituent elements.

The size and thickness of each configuration shown in the drawings are arbitrarily shown for better understanding and ease of description unless otherwise described, and the present disclosure is not limited thereto. For example, when a specific size or position relationship among elements is described with reference to a drawings, the drawing is intended to show such a size or position relationship. The thicknesses of layers, films, panels, regions, etc., may be exaggerated for clarity unless otherwise described. For example, when a specific thickness relationship among elements is described with reference to a drawing, the drawing is intended to show such a thickness relationship. The thicknesses of some layers and areas may be exaggerated.

The singular forms are intended to include the plural forms as well, unless the context clearly indicates otherwise.

In the specification and the claims, the term "and/or" is intended to include arbitrary combinations of the terms "and" and "or" for the purposes of meaning and interpretation. For example, the expression of "A and/or B" may be understood to signify "A, B, or A and B".

In the specification and claims, the phrase "at least one of" is intended to include the meaning of "at least one selected from the group of," for the purpose of meaning and interpretation. For example, "at least one of A and B" may be understood to signify "A, B, or A and B".

Terms such as first, second, and the like will be used only to describe various constituent elements, and are not to be interpreted as limiting these constituent elements. The terms are only used to differentiate one constituent element from other constituent elements. For example, a first constituent element could be termed a second constituent element, and similarly, a second constituent element could be termed as a first constituent element, without departing from the scope of the present disclosure.

When an element, such as a layer, a film, a region, or a substrate is described to be "above" another element, it may be directly above another element or there may be an intermediate element. In contrast, when a first element is described to be "directly above" a second element, there is no intermediate element. Throughout the specification, the term "above" a target must be "understood as being disposed above or below the target element, and does not necessarily signify "above" with respect to an opposite direction of gravity.

For example, spatially relative terms "below" or "above" may be used to facilitate the description of the relationship of one element or a constituent element to other constituent elements as shown in the drawings. The spatially relative terms are intended to include other directions in use or operation in addition to the directions shown in the drawings. For example, when the device shown in the drawing is flipped, the device disposed below another device may be disposed "above" the other device. Therefore, the exemplary term "below" may include lower and upper positions. The device may also be oriented in other directions, the spatially relative term may be analyzed differently depending on the directions.

When an element (or region, layer, portion, etc.) is described to be "connected" or "combined" to another element in the specification, it may be directly disposed, connected, or combined on the above-noted other element, or an element may be disposed therebetween.

The term "connected to" or "combined to" may include physical or electrical connections or combinations.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

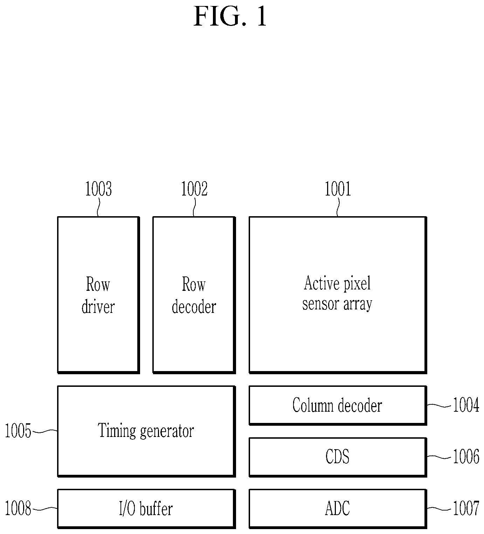

FIG. 1 shows a block diagram of an image sensor according to an embodiment.

Referring to FIG. 1, the image sensor may include an active pixel sensor array 1001, a row decoder 1002, a row driver 1003, a column decoder 1004, a timing generator 1005, a correlated double sampler CDS 1006, an analog to digital converter ADC 1007, and an input and output (I/O) buffer 1008.

The active pixel sensor array 1001 may include a plurality of unit pixels arranged in a two-dimensional (2D) way, and may convert optical signals into electrical signals. The active pixel sensor array 1001 may be driven by driving signals such as a pixel selection signal, a reset signal, and a charge transmitting signal from the row driver 1003. The converted electrical signals may be provided to the correlated double sampler 1006.

The row driver 1003 may provide driving signals for driving unit pixels to the active pixel sensor array 1001 according to decoded results by the row decoder 1002. When the unit pixels are arranged in a matrix form, the driving signals may be provided for respective rows.

The timing generator 1005 may provide timing signals and control signals to the row decoder 1002 and the column decoder 1004.

The correlated double sampler CDS 1006 may receive the electric signals generated by the active pixel sensor array 1001 and may hold and sample them. The correlated double sampler 1006 may sample a specific noise level and a signal level caused by the electrical signal, and may output a difference level that corresponds to a difference between the noise level and the signal level.

The analog to digital converter ADC 1007 may convert an analog signal that corresponds to the difference level output by the correlated double sampler 1006 into a digital signal and may output the digital signal.

The input and output buffer 1008 may latch the digital signal, and may sequentially output the latched signal to a video signal processor (not shown) according to a decoding result of the column decoder 1004.

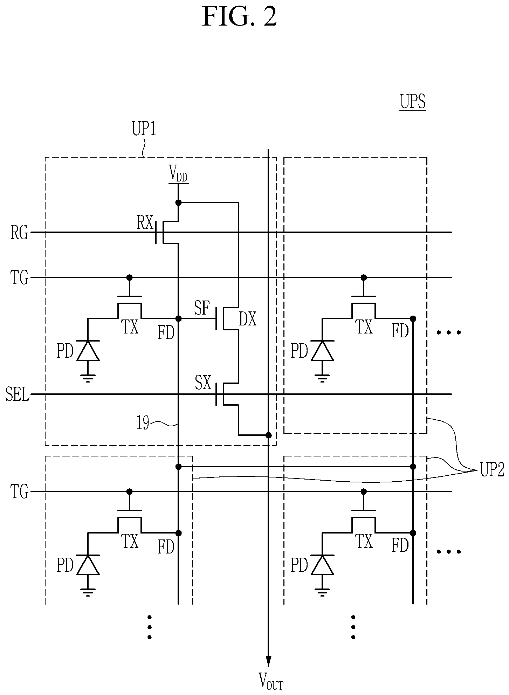

FIG. 2 shows a circuit diagram of an active pixel sensor array of an image sensor according to an embodiment.

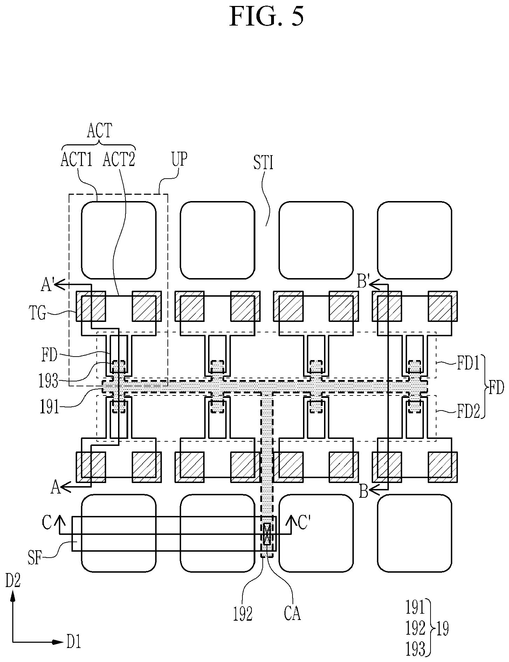

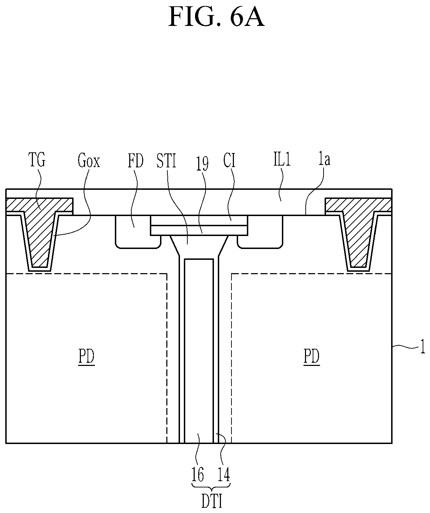

Referring to FIG. 1 and FIG. 2, the active pixel sensor array 1001 may include a plurality of unit pixels UPS. The unit pixels UPS may be arranged in a matrix format. The respective unit pixels UPS may include a transmission transistor TX. The respective unit pixels UPS may further include some or entire logic transistors RX, SX, and DX. The logic transistor may be a reset transistor RX, a selection transistor SX, or a source follower transistor DX. The transmission transistor TX may include a transmission gate TG (i.e., a transmission gate line or a transmission gate electrode). The transmission gate TG may be a dual transmission gate in which two transmission gates make a pair. The respective unit pixels UPS may further include a photoelectric converter PD and a floating diffusion region FD. The respective unit pixels UPS may include at least one photoelectric converter PD. In some embodiments, the respective unit pixels UPS may include a first sub-unit pixel UP1 and a plurality of second sub-unit pixels UP2. The first sub-unit pixel UP1 may include a photoelectric converter PD, a transmission transistor TX, a floating diffusion region FD, a reset transistor RX, a source follower transistor DX, a selection transistor SX. Each of the plurality of second sub-unit pixels UP2 may include a photoelectric converter PD, a floating diffusion region FD, and a transmission gate TG selectively connecting the photoelectric converter PD to the floating diffusion region FD. The floating diffusion region FD of each second sub-unit pixel UP2 may be connected to the FD of the first unit pixel UP1 via a floating diffusion region connector 19, which will be described with reference to FIGS. 5 and 6A to 6C. Each second sub-unit pixel UP2 may share the logic transistors RX, DX, and SX of the firs sub-unit pixel UP1. The logic transistors RX, SX, and DX may be shared with each other for the respective sub-unit pixels UP1 and UP2. For example, each unit pixel UPS may have one first sub-unit pixel and seven second sub-unit pixels, and eight sub-unit pixels UP1 and UP2 may share one set of logic transistors RX, SX, and DX. The present disclosure is not limited thereto. In some embodiments, each unit pixel has eight sub-unit pixels having a photoelectric converter, a floating diffusion region, and a transmission transistor selectively connecting the photoelectric converter and the floating diffusion region, and the logic transistors RX, SX, and DX may be divided and disposed on some or entire eight sub-unit pixels. Hereinafter, the sub-unit pixels UP1 and UP2 may be referred to using the reference UP.

The photoelectric converter PD may generate and store photocharges in proportion to an amount of light input by an outside. The photoelectric converter PD may include a photodiode, a phototransistor, a photogate, a pinned photodiode, or a combination thereof. The transmission transistor TX may transmit the charges generated by the photoelectric converter PD to the floating diffusion region FD. The floating diffusion region FD may receive the charges generated by the photoelectric converter PD and may store them in an accumulative way. The source follower transistor DX may be controlled according to the amount of photocharges accumulated in the floating diffusion region FD.

The reset transistor RX may periodically reset the charges accumulated in the floating diffusion region FD. A drain electrode of the reset transistor RX may be connected to the floating diffusion region FD, and a source electrode may be connected to a power voltage VDD. When the reset transistor RX is turned on, the power voltage VDD connected to the source electrode of the reset transistor RX may be applied to the floating diffusion region FD. Therefore, when the reset transistor RX is turned on, the charges accumulated in the floating diffusion region FD may be discharged and the floating diffusion region FD may be reset.

The source follower transistor DX including a source follower gate SF (i.e., a source follower gate line or a source follower gate electrode) may function as a source follower buffer amplifier. The source follower transistor DX may amplify a potential change in the floating diffusion region FD, and may output the amplified result to an output line Vout.

The selection transistor SX including a selection gate electrode SEL (i.e., a selection gate line) may select the sub-unit pixels UP to be read for respective rows. When the selection transistor SX is turned on, the power voltage VDD may be applied to a drain electrode of the source follower transistor DX.

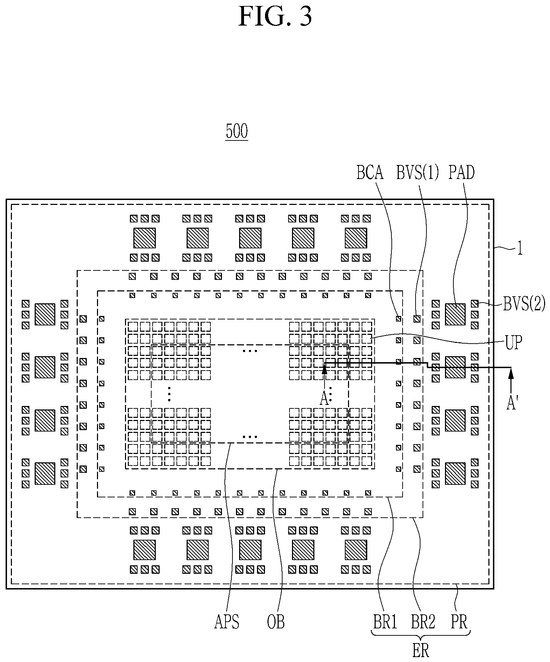

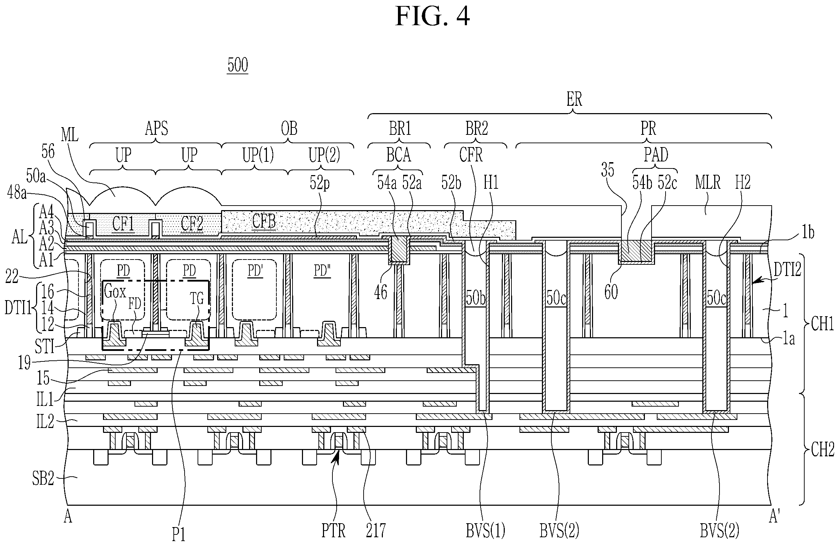

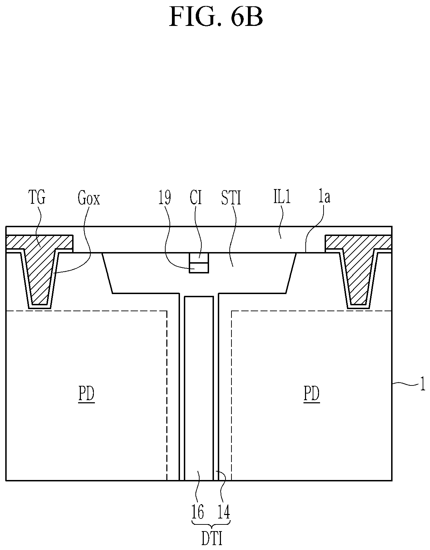

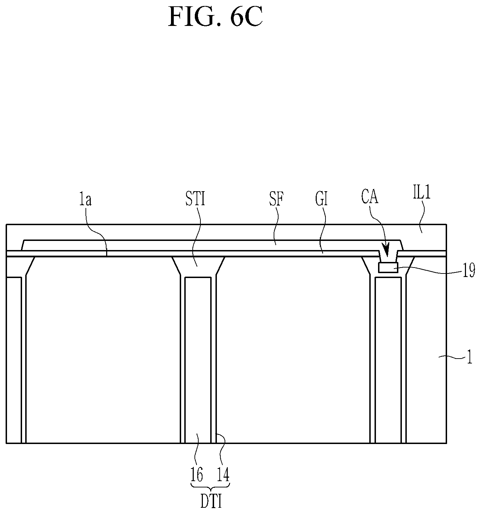

FIG. 3 shows a top plan view of an image sensor according to an embodiment. FIG. 4 shows a cross-sectional view taken along line A-A' of FIG. 3. FIG. 5 shows an enlarged top plan view on disposition of a transmission gate, a floating diffusion region, a floating diffusion region connector, and a source follower gate in an image sensor according to an embodiment. FIG. 6A shows a cross-sectional view taken along line A-A' of FIG. 5, corresponding to a region P1 of FIG. 4. FIG. 6B shows a cross-sectional view taken along line B-B' of FIG. 5. FIG. 6C shows a cross-sectional view taken along line C-C' of FIG. 5.

Referring to FIG. 3 and FIG. 4, the image sensor 500 may have a structure in which a first sub-chip CH1 and a second sub-chip CH2 are bonded. The first sub-chip CH1 may be disposed on the second sub-chip CH2. The first sub-chip CH1 includes a first substrate 1. The first substrate 1 may, for example, be a silicon monocrystalline wafer, a silicon epitaxial layer, or a silicon on insulator (SOI) substrate. The first substrate 1 may, for example, be doped with first conductive type impurities. For example, the first conductive type may be a P-type. The first substrate 1 includes a front side 1a and a rear side 1b that are opposite to each other. In the present specification, the front side 1a may be referred to as a first side 1a, and the rear side 1b may be referred to as a second side 1b. The first substrate 1 may include a pixel array region APS, an optical black region OB, and an edge region ER.

The pixel array region APS and the optical black region OB may include sub-unit pixels UP. Each of the sub-unit pixels UP may be the first sub-unit pixel UP1 or one of the second sub-unit pixels UP2 depending on whether the logic transistors RX, SX, and DX are disposed as discussed above with reference to FIG. 2. The optical black region OB may surround the pixel array region APS. The edge region ER may surround the pixel array region APS and the optical black region OB. The edge region ER may include a contact region BR1, a via region BR2, and a pad region PR. The via region BR2 may be disposed between the contact region BR1 and the pad region PR. The pad region PR may be disposed on an outermost portion in the edge region ER.

A first pixel separator DTI1 may be disposed in the first substrate 1 and may separate/define the unit pixels UP in the pixel array region APS and the optical black region OB. The first pixel separator DTI1 may penetrate the first substrate 1 and extend to the contact region BR1 of the edge region ER. The first pixel separator DTI1 may have a mesh shape when viewed in a plan view.

Rear side contacts BCA, rear side vias BVS, and rear side conductive pads PAD may be disposed on a rear side 1b of the first substrate 1 in the edge region ER. The rear side vias BVS may include first rear side vias BVS(1) and second rear side vias BVS(2).

The first pixel separator DTI1 and the second pixel separators DTI2 may be disposed in a deep trench 22 formed toward the rear side 1b from a front side 1a of the first substrate 1. The first pixel separator DTI1 and the second pixel separators DTI2 may be frontside deep trench isolators (FDTI). The first pixel separator DTI1 and the second pixel separators DTI2 may include a buried insulation pattern 12, an isolated insulation pattern 14, and an isolated conductive pattern 16. The buried insulation pattern 12 may be disposed between the isolated conductive pattern 16 and a first interlayer insulating layer IL. The isolated insulation pattern 14 may be provided between the isolated conductive pattern 16 and the first substrate 1 and between the buried insulation pattern 12 and the first substrate 1.

The buried insulation pattern 12 and the isolated insulation pattern 14 may be made of an insulating material with a refractive index that is different from that of the first substrate 1. The buried insulation pattern 12 and the isolated insulation pattern 14 may include or may be formed of, for example, silicon oxide. The isolated conductive pattern 16 may be spaced apart from the first substrate 1. The isolated conductive pattern 16 may include or may be a polysilicon film doped with impurities or a silicon germanium film doped with impurities. The impurities doped to the polysilicon or the silicon germanium film may, for example, be one of boron, phosphorus, arsenide. In some embodiments, the isolated conductive pattern 16 may include or may be a metal layer.

The first pixel separator DTI1 and the second pixel separators DTI2 have horizontal cross-sections that become narrower when approaching the rear side 1b from the front side 1a of the first substrate 1 as shown in FIG. 4. The second pixel separator DTI2 may be referred to as a substrate separator.

The photoelectric converters PD may be disposed in the first substrate 1. The photoelectric converters PD may be doped with second conductivity type impurities that are opposite to the first conductivity type. The second conductivity type may, for example, be an N-type. The N-type impurities doped to the photoelectric converter PD may make a PN junction with P-type impurities doped to the adjacent first substrate 1 and may provide a photodiode. At least two photoelectric converters PD may be disposed in one sub-unit pixel UP.

A shallow trench isolator STI provided near the front side 1a may be disposed in the first substrate 1. The first pixel separator DTI1 may penetrate the shallow trench isolator STI. In the respective sub-unit pixels UP, the shallow trench isolator STI may limit or define active regions ACT disposed near the front side 1a. The active regions ACT may be provided for the transistors TX, RX, DX, and SX of FIG. 2. A floating diffusion region connector 19 for connecting floating diffusion regions FD to be described may be buried and disposed in the shallow trench isolator STI. The floating diffusion region connector 19 may penetrate the first pixel separator DTI1 penetrating the shallow trench isolator STI or may extend along the first pixel separator DTI1. The floating diffusion region connector 19 may include or may be a polysilicon film doped with impurities, a silicon germanium film doped with impurities, or metal.

Referring to FIG. 4, in the respective sub-unit pixels UP, the transmission gate TG may be disposed on the front side 1a of the first substrate 1. A portion of the transmission gate TG may extend into the first substrate 1. The transmission gate TG may be a vertical type. In some embodiments, the transmission gate TG may not extend into the first substrate 1 but may be planar, that is, it may be a planar type. The transmission gate TG may be a dual transmission gate in which two separated ones make a pair. A gate oxide layer Gox may be disposed between the transmission gate TG and the first substrate 1.

Floating diffusion regions FD may be disposed in the first substrate 1 on one side of the transmission gate TG. The floating diffusion regions FD may be electrically connected with each other through the floating diffusion region connector 19. For example, as shown in FIG. 5, the eight floating diffusion regions FD may be connected with each other through the floating diffusion region connector 19. The number of the floating diffusion regions FD connected with each other through the floating diffusion region connector 19 may be equal to the number of the unit pixels UP sharing the source follower transistor DX. The floating diffusion region FD may be part of the first substrate 1 which is doped with second conductivity type impurities(i.e., polysilicon or silicon germanium doped with second conductivity type impurities)., or a metal. The floating diffusion region connector 19 may include or may be formed of, for example, polysilicon or silicon germanium which is doped with second conductivity type impurities or metal.

The image sensor 500 may be a rear-side light receiving image sensor. Light may be input into the first substrate 1 through the micro lens ML disposed on the rear side 1b of the first substrate 1. Electron-hole pairs may be generated at the PN junction by the incident light. The generated electrons may move to the photoelectric converter PD. When a voltage is applied to the transmission gate TG, the electrons may move to the floating diffusion region FD.

A first unit pixel UP(1) and a second unit pixel UP(2) may be disposed in the optical black region OB of the first substrate 1. A black photoelectric converter PD' is provided in the first unit pixel UP(1) of the first substrate 1. A dummy region PD" may be provided in the second unit pixel UP(2) of the first substrate 1. The black photoelectric converter PD' may be doped with, for example, the second conductivity type impurities that are not the first conductivity type. The second conductivity type may be, for example, an N-type. The pixel array region APS may include sub-unit pixels UP. The black photoelectric converter PD' may have a similar structure to the photoelectric converter PD, and may not perform an operation (i.e., an operation for receiving light and generating electrical signals) performed by the photoelectric converter PD. The blank region PD" may not be doped with impurities to form a structure which is similar to the photoelectric converter PD. A signal generated by the blank region PD" may be used as information for removing noise.

The first sub-chip CH1 may further include first interlayer insulating layers IL1 disposed on the front side 1a. The first interlayer insulating layers IL1 may be made of a multilayer of at least one film selected from among a silicon oxide layer, a silicon nitride, a silicon oxynitride layer, and a porous low-dielectric layer. First wires 15 may be disposed between or in the first interlayer insulating layers IL1. The floating diffusion region FD may be connected to the first wires 15 by a first contact plug. The first contact plug may penetrate a first interlayer insulating layer, which is disposed the nearest (or the lowest) the front side 1a, from among the first interlayer insulating layers IL1 in the pixel array region APS.

The second sub-chip CH2 may include a second substrate SB2, peripheral transistors PTR disposed thereon, and second interlayer insulating layers IL2 for covering the same. Second wires 217 may be disposed in the second interlayer insulating layers IL2. The second sub-chip CH2 may include circuits for storing electrical signals generated by the first sub-chip CH1.

Referring to FIG. 4, an antireflection structure AL may be disposed on the rear side 1b of the first substrate 1. The antireflection structure AL may include a first insulation layer A1, a conductive film A2, a second insulation layer A3, and a third insulation layer A4 that are sequentially stacked. The first insulation layer A1, the second insulation layer A3, and the third insulation layer A4 may include or may be formed of different materials. In an embodiment, the first insulation layer A1 may include or may be formed of aluminum oxide, the second insulation layer A3 may include or may be formed of silicon oxide, and the third insulation layer A4 may include or may be formed of hafnium oxide. The conductive film A2 may have electrical conductivity and may include or may be formed of titanium oxide. In some embodiments, the conductive film A2 may include or may be formed of a conductive oxide such as titanium oxide.

In the present specification, the first insulation layer A1 may be referred to as a first antireflection layer, the conductive film A2 may be referred to as a second antireflection layer, the second insulation layer A3 may be referred to as a third antireflection layer, and the third insulation layer A4 may be referred to as a fourth antireflection layer.

The first substrate 1 may have a first refractive index n1, the first insulation layer A1 may have a second refractive index n2, the conductive film A2 may have a third refractive index n3, and the second insulation layer A3 may have a fourth refractive index n4. A mean value {(n2+n3)/2} of the second refractive index n2 and the third refractive index n3 may be less than the first refractive index n1 and may be greater than the fourth refractive index n4. The first refractive index n1 may be a value selected from a range of 4.0 to 4.4. The second refractive index n2 may be a value selected from a range of 2.0 to 3.0. The third refractive index n3 may be a value selected from a range of 2.2 to 2.8. The fourth refractive index n4 may be a value selected from a range of 1.0 to 1.9.

The first insulation layer A1 may have a first thickness T1, the conductive film A2 may have a second thickness T2, the second insulation layer A3 may have a third thickness T3, and the third insulation layer A4 may have a fourth thickness T4. Here, the second thickness T2 may be greater than each of the first thickness T1 and the fourth thickness T4, and may be less than the third thickness T3. The first thickness T1 may be a value selected from a range of 10Å to 100Å. The second thickness T2 may be a value selected from a range of 100Å to 600Å. The third thickness T3 may be a value selected from a range of 600Å to 900Å. The fourth thickness T4 may be a value selected from a range of 20Å to 200Å.

According to a relationship of the refractive indexes and/or a relationship of the thicknesses, light L1 input to a micro lens ML may be refracted and pass through a multilayered structure of the antireflective structure AL and may be input to the photoelectric converter PD. Hence, the image sensor 500 with clear image quality may be provided by increasing a light receiving rate.

Regarding the image sensor 500, the antireflective structure AL may include a conductive film A2 made of titanium oxide (TiO₂), and the conductive film A2 made of titanium oxide may generally reduce reflectance of light of all colors, and may particularly further reduce the reflectance of blue light. Hence, a quantum efficiency (QE) of the blue pixel may be increased.

The first insulation layer A1 may function as a negative fixed charge layer. Hence, dark currents and white spots may be reduced.

Further, a predetermined negative potential (voltage) may be applied to the conductive film A2 so that holes (h+), which are generated from light incident on the rear side 1b of the first substrate 1, may be accumulated around the rear side 1b of the first substrate 1. By this, the dark currents and the white spots may be further reduced.

Referring to FIG. 3 and FIG. 4, rear side contacts BCA may be disposed at the contact region BR1 of the rear side 1b of the first substrate 1. First rear side vias BVS(1) may be disposed at the via region BR2 of the rear side 1b of the first substrate 1. Rear side conductive pads PAD and second rear side vias BVS(2) may be disposed at the pad region PR of the rear side 1b of the first substrate 1. The second rear side vias BVS(2) may include a plurality of groups, and second rear side vias in each group may be adjacent to a corresponding one of the rear side conductive pads PAD. The second rear side vias in each group may be arranged in two rows or two columns, and a corresponding rear side conductive pad of the rear side conductive pads PAD may be disposed in a space between the two rows or the two columns.

Referring to FIG. 4, the rear side contacts BCA may penetrate at least part of the antireflection structure AL and the first substrate 1. The rear side contacts BCA may be disposed in a first rear side trench 46. The rear side contacts BCA may include a first conductive pattern 52a and a first metal pattern 54a. The first conductive pattern 52a may conformally cover a lateral side and a bottom side of the first rear side trench 46, and may contact the conductive film A2 of the antireflection structure AL, and may be electrically connected to the conductive film A2. The first conductive pattern 52a may be a single layer selected from a titanium layer, a titanium nitride layer, and a tungsten layer or a multilayer of at least one thereof. The first metal pattern 54a may include or may be formed of, for example, aluminum. The first metal pattern 54a may fill the first rear side trench 46. The term "contact," as used herein, refers to a direct connection (i.e., physical touching) unless the context indicates otherwise.

The rear side contacts BCA may contact the isolated conductive pattern 16 of the first pixel separator DTI1. The rear side contacts BCA may be connected to the first rear side vias BVS(1) through the rear side connecting wire 52b to receive a predetermined negative potential, and may apply the predetermined negative potential to the isolated conductive pattern 16 of the first pixel separator DTI1. The isolated conductive pattern 16 may function as a common bias line. The isolated conductive pattern 16 may hold holes at a surface of the first substrate 1 contacting the first pixel separator DTI1, thereby reducing the dark currents.

The first rear side vias BVS(1) are respectively disposed in first holes H1. The first rear side vias BVS(1) may penetrate the antireflection structure AL, the first substrate 1, and the first interlayer insulating layers IL1, and may partially penetrate the second interlayer insulating layers IL2. The first rear side vias BVS(1) may connect some of first wires 15 of the first sub-chip CH1 and some of second wires 217 of the second sub-chip CH2. The first rear side vias BVS(1) may conformally fill an interior wall and a bottom side of the first holes H1. The first rear side vias BVS(1) may include or may be formed of a same material as the first conductive pattern 52a and may have a same thickness. The first rear side vias BVS(1) may be a single layer selected from a titanium layer, a titanium nitride layer, and a tungsten layer or a multilayer of at least one thereof.

One of the first rear side vias BVS(1) may be electrically connected to one of the rear side contacts BCA by one of the rear side connecting wires 52b. The rear side connecting wire 52b may include or may be formed of a same material as the first conductive pattern 52a and may have a same thickness. The rear side connecting wire 52b may be a single layer selected from a titanium layer, a titanium nitride layer, and a tungsten layer or a multilayer of at least one thereof.

The rear side conductive pad PAD may be disposed in a second rear side trench 60. The rear side conductive pad PAD may include a second conductive pattern 52c and a second metal pattern 54b. The second conductive pattern 52c may conformally cover the lateral side and the bottom side of the second rear side trench 60. The second conductive pattern 52c may have a same material as the first conductive pattern 52a and may have a same thickness. The second conductive pattern 52c may be a single layer selected from a titanium layer, a titanium nitride layer, and a tungsten layer or a multilayer of at least one thereof. The second metal pattern 54b may include or may be formed of, for example, aluminum. The second metal pattern 54b may fill the second rear side trench 60.

The second rear side vias BVS(2) are respectively disposed in second holes H2. The second rear side vias BVS(2) may penetrate the first insulation layer A1 of the antireflection structure AL, the first substrate 1, the first interlayer insulating layer IL1, and at least one of the second interlayer insulating layers IL2. The second rear side vias BVS(2) may be connected to corresponding wires of the second wires 217. Although not shown, the second rear side vias BVS(2) may be connected to corresponding wires of the first wires 15. The second rear side vias BVS(2) may conformally fill an interior wall and a bottom side of the second holes H2. The second rear side vias BVS(2) may have or may be formed of a same material as the first conductive pattern 52a and may have a same thickness. The second rear side vias BVS(2) may be a single layer selected from a titanium layer, a titanium nitride layer, and a tungsten layer or a multilayer of at least one thereof. One of the second rear side vias BVS(2) may be electrically connected to one of the rear side conductive pads PAD by one of the rear side connecting wires 52b.

A first optical black pattern 52p may be disposed in the antireflection structure AL in the edge region ER. The first optical black pattern 52p may have a same material as the first conductive pattern 52a and may have a same thickness. The first optical black pattern 52p may be a single layer selected from a titanium layer, a titanium nitride layer, and a tungsten layer or a multilayer of at least one thereof.

Light blocking grid patterns 48a may be disposed in the antireflection structure AL in the pixel array region APS. Low-refraction grid patterns 50a may be disposed on the light blocking grid patterns 48a. The light blocking grid pattern 48a and the low-refraction grid pattern 50a may overlap the first pixel separator DTI1 and may have a grid shape when viewed in a plan view. The light blocking grid pattern 48a may include or may be formed of, for example, at least one of titanium and titanium nitride. The low-refraction grid pattern 50a may have a same thickness and may include or may be formed of a same organic material. The low-refraction grid pattern 50a may have a refractive index that is less than those of the color filters CF1 and CF2. For example, the low-refraction grid pattern 50a may have the refractive index of equal to or less than about 1.3. The light blocking grid pattern 48a and the low-refraction grid pattern 50a may prevent crosstalk among adjacent sub-unit pixels UP. Terms such as "about" or "approximately" may reflect amounts, sizes, orientations, or layouts that vary only in a small relative manner, and/or in a way that does not significantly alter the operation, functionality, or structure of certain elements. For example, a range from "about 0.1 to about 1" may encompass a range such as a 0%-5% deviation around 0.1 and a 0% to 5% deviation around 1, especially if such deviation maintains the same effect as the listed range.

The color filters CF1 and CF2 may be disposed among the low-refraction grid patterns 50a in the pixel array region APS. The color filters CF1 and CF2 may have one of blue, green, and red colors. For example, the color filters CF1 and CF2 may include other colors such as cyan, magenta, and yellow. The color filters CF1 and CF2 may be arranged in a Bayer pattern in the image sensor according to the present embodiment. For example, the color filters CF1 and CF2 may be arranged in a 2x2 tetra pattern, a 3x3 nona pattern, or a 4x4 hexadeca pattern. The color filters CF1 and CF2 may have a one-to-one correspondence relationship with the unit pixels UP or a one-to-plural correspondence relationship. For example, one unit pixel UP may be disposed at a position corresponding to each of the color filters CF1 and CF2, two adjacent unit pixels UP may be disposed at it, or four adjacent unit pixels UP may be disposed at it.

A capping pattern CFR may be disposed on the first low-refraction protection pattern 50b filling an insides of the first rear side vias BVS(1) and the second low-refraction protection pattern 50c filling an insides of the second rear side vias BVS(2). The capping pattern CFR may include or may be formed of, for example, a photoresist material.

A protective layer 56 may be conformally disposed on a low-refraction grid pattern 50a, a first conductive pattern 52a, a first metal pattern 54a, a second conductive pattern 52c, a rear side connecting wire 52b, a first optical black pattern 52p, a capping pattern CFR, and a low-refraction residual pattern 50r.

A second optical black pattern CFB may be disposed on the protective layer 56. The second optical black pattern CFB may include a same material as, for example, the blue color filter.

Micro lenses ML may be disposed on the color filters CF1 and CF2 in the pixel array region APS. Edges of the micro lenses ML may contact each other and may be connected with each other. The micro lenses ML may be arranged in an array. The micro lenses ML may be referred to as a micro lens array.

Referring to FIG. 5, FIG. 6A, FIG. 6B, and FIG. 6C, in each sub-unit pixel UP, the active regions ACT, the transmission gate TG, the floating diffusion region FD, and the photoelectric converter PD may be disposed.

The active regions ACT may be partitioned by the shallow trench isolator STI. In some embodiments, one sub-unit pixel UP may include multiple active regions divided by the shallow trench isolator STI. For example, as shown in FIG. 5, the first active region ACT1 and the second active region ACT2 may be disposed on one sub-unit pixel UP, the source follower transistor DX and some or entire logic transistors RX, SX, and DX may be disposed in the first active region ACT1, and the transmission transistor TX may be disposed in the second active region ACT2.

Two transmission gates TG that are the gate electrodes of the transmission transistor TX may make a pair so that they may at least partly overlap the second active region ACT2.

The floating diffusion region FD may be disposed on one side of the second active region ACT2, and the floating diffusion regions FD of the two neighboring sub-unit pixels UP may face each other with the shallow trench isolator STI therebetween.

A floating diffusion region connector 19 for electrically connecting the floating diffusion regions FD may be disposed in the shallow trench isolator STI. For example, the floating diffusion region connector 19 may be buried in the shallow trench isolator STI and an upper surface of the floating diffusion region connector 19 may be lower than an upper surface of the shallow trench isolator STI. The floating diffusion region connector 19 may include a stem 191 (i.e., a stem portion), a first branch 192 (i.e., a first branch portion) extending from the stem 191 and connected to the source follower gate SF, and a second branch 193 (i.e., a second branch portion) extending from the stem 191 and connected to the floating diffusion region FD. The floating diffusion region connector 19 may, for example, connect eight floating diffusion regions FD to each other, as shown in FIG. 5. The number of the floating diffusion regions FD connected by one floating diffusion region connector 19 may be less or greater than eight. The floating diffusion region connector 19 may include or may be formed of, for example, polysilicon doped with impurities or silicon germanium doped with impurities, or metal such as aluminum, copper, and silver. The floating diffusion region connector 19 may fill part of the groove formed in the shallow trench isolator STI, and a cover insulating layer CI may cover the floating diffusion region connector 19. The cover insulating layer CI may fill the other part of the groove formed in the shallow trench isolator STI, and an upper side of the cover insulating layer CI may correspond to an upper side of the shallow trench isolator STI, which is not limited thereto. In some embodiments, the cover insulating layer CI may be disposed on the shallow trench isolator STI. In some embodiments, the floating diffusion region connector 19 may include the stem portion 191 extending along a straight line extending in a first direction D1, the first branch portion 192 extending along a straight line extending in a second direction D2 and connecting the stem portion 191 to the source follower gate electrode SF, and a second branch portion 193 extending along a straight line extending in the second direction D2 and connected to a corresponding floating diffusion region of the plurality of floating diffusion regions FD. The plurality of floating diffusion regions FD may include a first group of floating diffusion regions FD1 and a second group of floating diffusion regions FD2. The first group of floating diffusion regions FD1 may be spaced apart from the second group of floating diffusion regions FD2 in the second direction D2. When viewed in a plan view, a portion of the shallow trench isolation structure STI may be disposed in a space between the first group of floating diffusion regions FD1 and the second group of floating diffusion regions FD2. The stem portion 191 may be disposed in a space between the first group of floating diffusion regions FD1 and the second group of floating diffusion regions FD2. For example, the stem portion 191 may be buried in the portion of the shallow trench isolation structure STI between the first group of floating diffusion regions FD1 and the second group of floating diffusion regions FD2. In some embodiments, the unit pixel UPS may include a plurality of transistors including the transmission transistors TX, the source follower transistor DX, the reset transistor RX, and the selection transistor SX. The unit pixel UPS may include a plurality of photoelectric converts (e.g., 8 photoelectric converters), and a plurality of first active regions ACT1 and a plurality of second active regions ACT2 among the plurality of active regions. At least one of the source follower transistor SF, the reset transistor RX, and the selection transistor SX may be disposed at one or more of the plurality of first active regions ACT1. The transmission transistors TX may be disposed in the plurality of second active regions ACT2. Each of the transmission transistors TX may selectively connect a corresponding photoelectric converter among the plurality of photoelectric converters PD to a corresponding floating diffusion region among the plurality of floating diffusion regions FD.

Referring to FIG. 6A, the floating diffusion region connector 19 may contact the first substrate 1 between the shallow trench isolator STI and the floating diffusion region FD. In some embodiments, the floating diffusion region connector 19 may be surrounded by the shallow trench isolator STI and the floating diffusion region FD and may not contact the first substrate 1.

Referring to FIG. 5 and FIG. 6C, a gate insulating layer GI may be disposed on the front side 1a of the first substrate 1, and a source follower gate SF may be disposed on the gate insulating layer GI. The gate insulating layer GI may be made of the same material as the gate oxide layer Gox between the transmission gate TG and the first substrate 1. In some embodiments, the gate insulating layer GI may be made of a different material from the gate oxide layer Gox. The source follower gate SF that is the gate electrode of the source follower transistor DX may be disposed in the two first active regions ACT1 adjacent. That is, the two first active regions ACT1 may realize one source follower transistor DX. The source follower gate SF may include or may be formed of polysilicon or silicon germanium doped with second conductivity type impurities, or metal.

A contact hole CA penetrating the cover insulating layer CI and the gate insulating layer GI may be disposed on the first branch 192 of the floating diffusion region connector 19, and the source follower gate SF may be connected to the floating diffusion region connector 19 through the contact hole CA.

When the floating diffusion region connector 19 is disposed in the shallow trench isolator STI as described above, a capacitive coupling formed between the wire disposed in the interlayer insulating layer may be reduced, and freedom of disposing wires may be increased. For example, when the wires overlap the floating diffusion region connector 19 buried in the shallow trench isolator STI, a parasitic capacitance therebetween may be reduced, and thus the routing of the wires can be arranged without constraints on the location of the floating diffusion region connector 19.

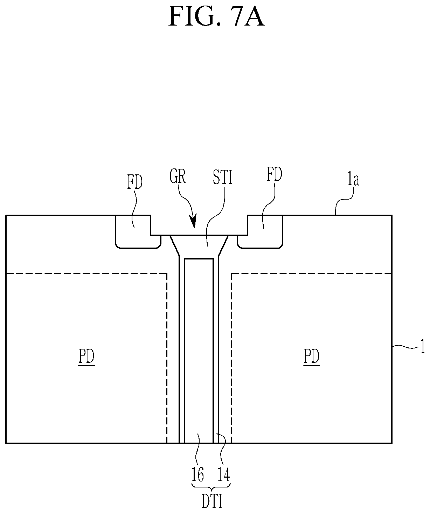

FIG. 7A to FIG. 7D show cross-sectional views of a method for forming a floating diffusion region connector of an image sensor according to an embodiment.

Referring to FIG. 7A, an ion implantation process may be performed on the first substrate 1 to form a photoelectric converter PD, and a shallow trench isolator STI may be formed on the front side 1a of the first substrate 1 to define active regions. The shallow trench isolator STI may be formed by using a shallow trench isolation process. A deep trench may be formed by etching part of the shallow trench isolator STI and the first substrate 1. An isolated insulation layer 14 (i.e., an isolated insulation pattern) may be conformally formed on the front side 1a of the first substrate 1, the deep trench may be filled with a conducting material, and an etch back process may be performed to form isolated conductive patterns 16 in the deep trench. Buried insulation patterns 12 may be formed on the isolated conductive patterns 16, the isolated insulation layer 14 on the front side 1a may be removed, and the front side 1a may be exposed. Hence, the pixel separator DTI may be formed. FIG. 7A to FIG. 7D show that the isolated insulation layer 14 and the buried insulation pattern 12 on the pixel separator DTI are not distinguished from the adjacent shallow trench isolator STI. The present disclosure is not limited thereto. In some embodiments, there may be a boundary between the isolated insulation layer 14 and the buried insulation pattern 12.

According to a conventional process, the floating diffusion region FD may be formed on the front side 1a of the first substrate 1, and a groove GR in which the floating diffusion region connector 19 is disposed may be formed on the shallow trench isolator STI by a photolithography method.

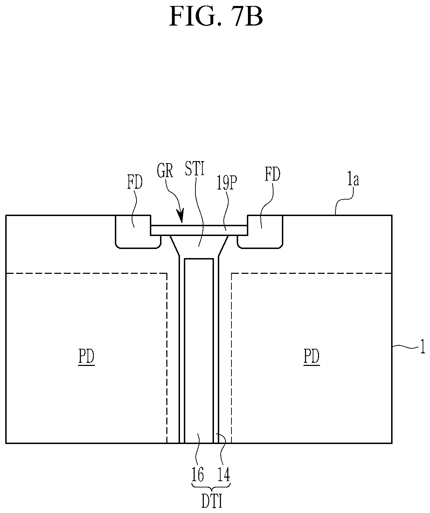

Referring to FIG. 7B, a preliminary floating diffusion region connector 19P may be formed by partly filling polysilicon or a metal in the groove GR. The preliminary floating diffusion region connector 19P may be formed by a film deposition, a plating, a CMP, and/or an etch back process.

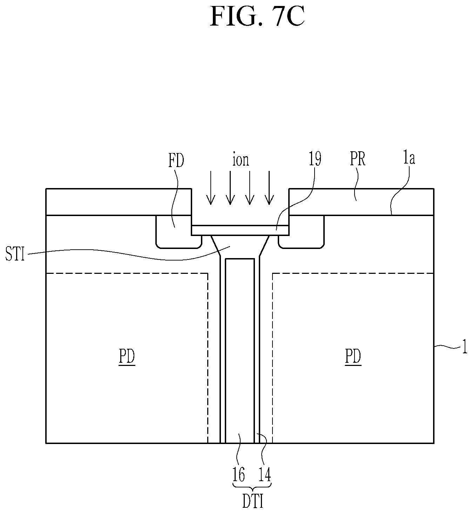

Referring to FIG. 7C, a photoresist pattern PR for exposing the preliminary floating diffusion region connector 19P may be formed by applying photoresist and developing the same, and the floating diffusion region connector 19 may be formed by doping second conductivity type impurity ions. This process may be omitted when forming the floating diffusion region connector 19 with a metal.

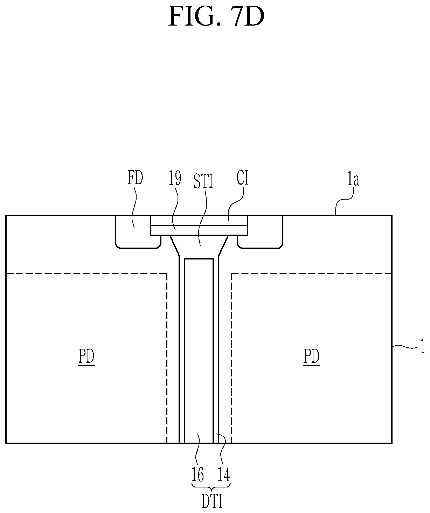

Referring to FIG. 7D, a cover insulating layer CI may be conformally formed on the photoresist pattern PR and the floating diffusion region connector 19, and the photoresist pattern PR may be ashed and removed, thereby removing the cover insulating layer CI disposed thereon. By this, the cover insulating layer CI for covering the floating diffusion region connector 19 may be formed. In some embodiments, the photoresist pattern PR may be removed, the cover insulating layer CI may be deposited or coated, or surfaces of the first substrate 1 and the floating diffusion region connector 19 may be oxidized to form the oxide layer as the cover insulating layer CI. By the method such as the CMP, the cover insulating layer CI for filling the groove GR in the floating diffusion region connector 19 may remain and other portions may be removed. In some embodiments, the cover insulating layer CI provided on the front side 1a of the first substrate 1 may not be removed but may be used as the interlayer insulating layer IL1 or the gate insulating layer GI.

The transmission gate TG and the source follower gate SF may be formed by performing the conventional process.

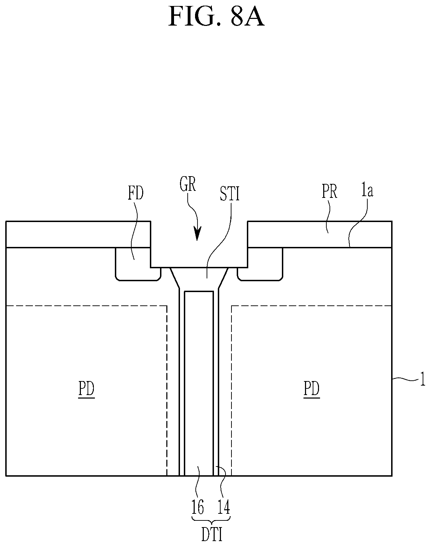

FIG. 8A to FIG. 8D show cross-sectional views showing a method for forming a floating diffusion region connector of an image sensor according to an embodiment.

Referring to FIG. 8A, an ion implantation process may be performed on the first substrate 1 to form a photoelectric converter PD, and a shallow trench isolator STI may be formed at the front side 1a of the first substrate 1 to define the active regions. The shallow trench isolator STI may be formed by a shallow trench isolation process. A deep trench may be formed by etching part of the shallow trench isolator STI and the first substrate 1. An isolated insulation layer 14 may be conformally formed on the front side 1a of the first substrate 1, the deep trench may be filled with a conducting material, and an etch back process may be performed to form isolated conductive patterns 16 in the deep trench. Buried insulation patterns 12 may be formed on the isolated conductive patterns 16, the isolated insulation layer 14 on the front side 1a may be removed, and the front side 1a may be exposed. Hence, the pixel separator DTI may be formed. FIG. 8A to FIG. 8D show that the isolated insulation layer 14 and the buried insulation pattern 12 on the pixel separator DTI are not distinguished from the adjacent shallow trench isolator STI but are integrally formed. The present disclosure is not limited thereto. In some embodiments, a boundary between the isolated insulation layer 14 and the buried insulation pattern 12 may be present.

According to a conventional process, the floating diffusion region FD may be formed on the front side 1a of the first substrate 1, the photoresist pattern PR is formed according to a lithographic process, and the first substrate 1 is etched with the photoresist pattern PR as a mask, to thus form the groove GR in which the floating diffusion region connector 19 is disposed on the shallow trench isolator STI.

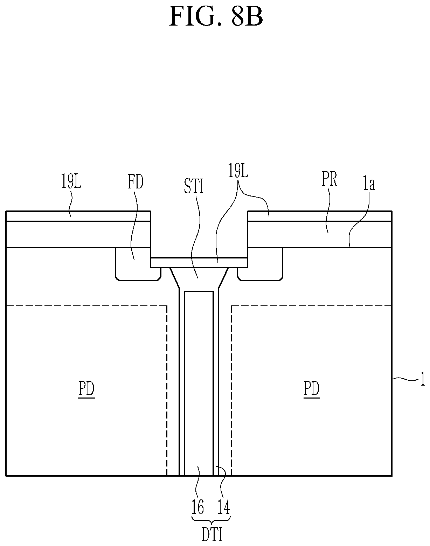

Referring to FIG. 8B, a preliminary floating diffusion region connector layer 19L may be formed by depositing polysilicon on the photoresist pattern PR and the groove GR.

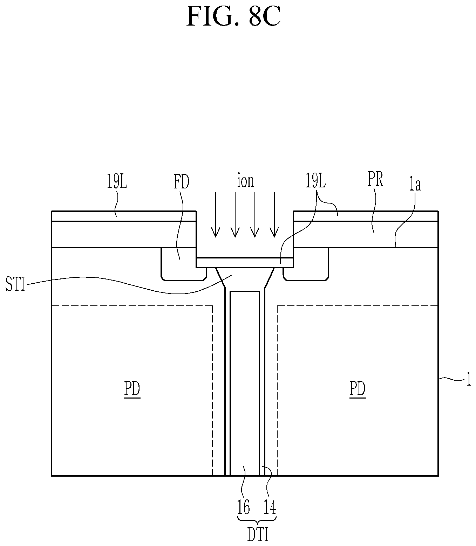

Referring to FIG. 8C, second conductivity type impurity ions may be doped on the preliminary floating diffusion region connector layer 19L.

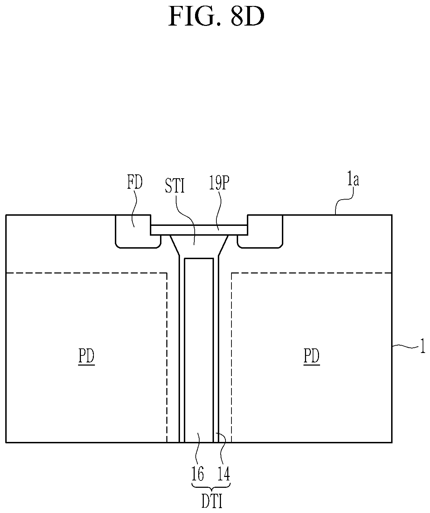

Referring to FIG. 8D, the floating diffusion region connector 19 may be formed by ashing the photoresist pattern PR and removing the same and the preliminary floating diffusion region connector layer 19L disposed thereon.

As described with reference to FIG. 7D, the oxide layer may be formed by depositing or applying the cover insulating layer CI, or oxidizing surfaces of the first substrate 1 and the floating diffusion region connector 19. The cover insulating layer CI for filling the groove GR in the floating diffusion region connector 19 may remain by the method such as the CMP, and the portion provided on the front side 1a of the first substrate 1 may be removed. In some embodiments, the cover insulating layer CI provided on the front side 1a of the first substrate 1 may not be removed but may be used as the interlayer insulating layer IL1 or the gate insulating layer GI.

According to a conventional process, the transmission gate TG and the source follower gate SF may be formed.

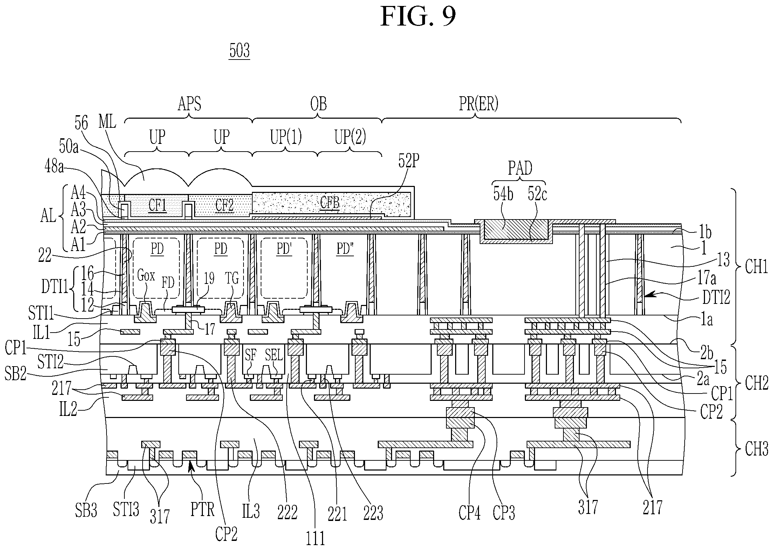

FIG. 9 shows a cross-sectional view of an image sensor according to an embodiment.

The image sensor 503 according to an embodiment of FIG. 9 may have a structure in which the first to third sub-chips CH1 to CH3 are sequentially bonded.

The first sub-chip CH1 may preferably perform an image sensing function. The first sub-chip CH1 may include a first substrate 1. The first substrate 1 may, for example, be a silicon monocrystalline wafer, a silicon epitaxial layer, or a silicon on insulator (SOI) substrate. The first substrate 1 may, for example, be doped with first conductive type impurities. For example, the first conductivity type may be a P-type. The first substrate 1 includes a front side 1a and a rear side 1b that are opposite to each other. In the present specification, the front side 1a may be referred to as a first side 1a, and the rear side 1b may be referred to as a second side 1b. The first substrate 1 may include a pixel array region APS, an optical black region OB, and an edge region ER.

The pixel array region APS and the optical black region OB may include sub-unit pixels UP. Micro lenses ML corresponding to the respective unit pixels UP may be disposed in the pixel array region APS.

The optical black region OB may surround the pixel array region APS. The edge region ER may surround the pixel array region APS and the optical black region OB. The edge region ER may include a pad region PR. The pad region PR may be disposed on an outermost portion in the edge region ER.

The first pixel separator DTI1 may be disposed in the first substrate 1 and may separate/define the sub-unit pixels UP in the pixel array region APS and the optical black region OB. The first pixel separator DTI1 may extend to the contact region BR1 of the edge region ER. The first pixel separator DTI1 may have a mesh shape when viewed in a plan view. The second pixel separator DTI2 may be disposed in the first substrate 1 in the edge region ER.

The first pixel separator DTI1 and the second pixel separators DTI2 are disposed in a deep trench 22 formed toward the rear side 1b from the front side 1a of the first substrate 1. The first pixel separator DTI1 and the second pixel separators DTI2 may be frontside deep trench isolators (FDTI). The first pixel separator DTI1 and the second pixel separators DTI2 may include a buried insulation pattern 12, an isolated insulation pattern 14, and an isolated conductive pattern 16. The buried insulation pattern 12 may be provided between the isolated conductive pattern 16 and the first interlayer insulating layer IL1. The isolated insulation pattern 14 may be provided between the isolated conductive pattern 16 and the first substrate 1 and between the buried insulation pattern 12 and the first substrate 1.

The buried insulation pattern 12 and the isolated insulation pattern 14 may be made of an insulating material with a refractive index that is different from that of the first substrate 1. The buried insulation pattern 12 and the isolated insulation pattern 14 may include or may be formed of, for example, silicon oxide. The isolated conductive pattern 16 may be spaced apart from the first substrate 1. The isolated conductive pattern 16 may include or may be a polysilicon film doped with impurities or a silicon germanium film doped with impurities. The impurities doped to the polysilicon film or the silicon germanium film may be one of boron, phosphorus, and arsenide, for example. In some embodiments, the isolated conductive pattern 16 may include or may be a metal layer.

The first pixel separator DTI1 and the second pixel separators DTI2 have horizontal cross-sections that become narrower when approaching the rear side 1b from the front side 1a of the first substrate 1. The second pixel separator DTI2 may be referred to as a substrate separator.

The photoelectric converters PD may be disposed in the first substrate 1. The photoelectric converters PD may be doped with second conductivity type impurities that are opposite to the first conductivity type. The second conductivity type may, for example, be an N-type. The N-type impurities doped to the photoelectric converter PD may make a PN junction with P-type impurities doped to the adjacent first substrate 1 and may provide a photodiode.

First shallow trench isolators STI1 provided near the front side 1a may be disposed in the first substrate 1. In some embodiments, the first shallow trench isolators STI1 may be connected with each other to define each of active regions. The first pixel separator DTI1 may penetrate the first shallow trench isolators STI1. The first shallow trench isolators STI1 may limit active regions disposed near the front side 1a. The active regions may be provided for the transistors TX, RX, DX, and SX of FIG. 2.

Referring to FIG. 9, in the respective sub-unit pixels UP, the transmission gate TG may be disposed on the front side 1a of the first substrate 1. A portion of the transmission gate TG may extend into the first substrate 1. The transmission gate TG may be a vertical type. In some embodiments, the transmission gate TG may not extend into the first substrate 1 but may be planar, that is, it may be a planar type. A gate oxide layer Gox may be disposed between the transmission gate TG and the first substrate 1.

The floating diffusion regions FD may be disposed in the first substrate 1 on one side of the transmission gate TG. The floating diffusion regions FD may be electrically connected with each other through the floating diffusion region connector 19. For example, as shown in FIG. 5, the eight floating diffusion regions FD may be connected with each other through the floating diffusion region connector 19. For example, each of the eight floating diffusion regions FD may collect charges generated from a corresponding photoelectric converter PD, and such charges of the eight floating diffusion regions FD may serve to selectively turn on the source follower transistor DX, thereby selectively outputting the power voltage VDD as an electrical signal corresponding to light incident on the unit pixels UPS. The number of the floating diffusion regions FD connected with each other through the floating diffusion region connector 19 may be equal to the number of the unit pixels UP sharing the source follower transistor DX. The floating diffusion region FD may be, for example, part of the first substrate 1 which is doped with second conductivity type impurities (i.e., polysilicon or silicon germanium doped with second conductivity type impurities. The floating diffusion region connector 19 may, for example, be polysilicon or silicon germanium to which second conductivity type impurities are doped, or a metal.

The transmission gate TG, the photoelectric converter PD, and the floating diffusion region FD may be disposed in the respective unit pixels UP disposed on the first sub-chip CH1. Some or all of the selection gates SEL, the source follower gates SF, and the reset gate RG may be disposed not on the first sub-chip CH1 but on the second sub-chip CH2. That is, some or all of the logic transistors RX, SX, and DX may be disposed on the second sub-chip CH2.

The image sensor 503 may be a rear-side light receiving image sensor. Light may be input into the first substrate 1 through the micro lens ML disposed on the rear side 1b of the first substrate 1. Electron-hole pairs may be generated at the PN junction by the incident light. The generated electrons may move to the photoelectric converter PD. When a voltage is applied to the transmission gate TG, the electrons may move to the floating diffusion region FD.

The first sub-chip CH1 may include a transmission gate TG and first interlayer insulating layers IL1 for covering the same on the front side 1a of the first substrate 1. The first shallow trench isolator STI1 may be disposed on the first substrate 1 to define the active regions. The first shallow trench isolator STI1 may bury the floating diffusion region connector 19.

The first sub-chip CH1 may further include internal connecting contacts 17a. At least one of the internal connecting contacts 17a may pass through the buried insulation pattern 12 of the first pixel separator DTI1 to connect some of the first wires 15 and the isolated conductive pattern 16 of the first pixel separator DTI1 in the edge region ER, and may apply a negative bias voltage to the isolated conductive pattern 16. At least another of the internal connecting contacts 17a may pass through the buried insulation pattern 12 of the second pixel separator DTI2 disposed below the rear side conductive pad PAD to connect some of the first wires 15 and the isolated conductive pattern 16 of the second pixel separator DTI2. A first conductive pad CP1 may be disposed on the first interlayer insulating layer IL1 on a lowest layer.

The first conductive pad CP1 may include or may be formed of copper.

The second sub-chip CH2 may include a second substrate SB2, selection gates SEL, source follower gates SF, and reset gates (not shown) disposed on the front side 2a of the second substrate SB2, and a second interlayer insulating layers IL2 for covering them. A second shallow trench isolator STI2 may be disposed on the second substrate SB2 to define the active regions, and an additional floating diffusion region (not shown) may be disposed in the active regions. Penetration holes may be disposed on the second substrate SB2, and penetration vias 222 may be disposed in the penetration holes. A second conductive pad CP2 may be disposed above the penetration via 222 to be thus exposed through the rear side 2b of the second substrate SB2. The second conductive pad CP2 may contact the first conductive pad CP1 of the first sub-chip CH1. A penetration hole insulation layer 111 may be filled around the penetration via 222 and the second conductive pad CP2. The penetration hole insulation layer 111 may be conformally disposed on the front side 2a of the second substrate SB2. Second wires 217 including a via 221 connected to the source follower gate SF and a via 223 connected to the active region of the second substrate SB2, and a third conductive pad CP3 may be disposed in the penetration hole insulation layer 111 and the second interlayer insulating layers IL2. The source follower gate SF may be connected to the floating diffusion region connector 19 of the first sub-chip CH1 through the penetration via 222, the second conductive pad CP2, the first conductive pad CP2, the first wires 15, and the first contact plug 17. In some embodiments, a portion of the second wires 217 may correspond to the source follower gate SF.

Referring to FIG. 9, the penetration via 222 may be disposed in the penetration hole passing through the second substrate SB2, and the second conductive pad CP2 may be disposed in the penetration via 222. The penetration hole insulation layer 111 may be filled around the penetration via 222 and the second conductive pad CP2 to insulate the second substrate SB2, the penetration via 222, and the second conductive pad CP2. A lower end of the penetration via 222 may be connected to the second wires 217. A width of a cross-section of the penetration via 222 may increase when becoming distant from the second conductive pad CP2, and a width of a cross-section of the second conductive pad CP2 may increase when becoming distant from the penetration via 222. The second conductive pad CP2 and the second wires 217 may include or may be formed of copper, and the penetration via 222 may include or may be formed of tungsten.

Referring to FIG. 9, the third sub-chip CH3 may include a third substrate SB3, peripheral transistors PTR disposed thereon, and third interlayer insulating layers IL3 for covering them. A third shallow trench isolator STI3 may be disposed on the third substrate SB3 to define the active regions. Third wires 317 and a fourth conductive pad CP3 may be disposed in the third interlayer insulating layers IL3. An uppermost layer of the third interlayer insulating layer IL3 contacts an uppermost layer of the second interlayer insulating layers IL2. The third sub-chip CH3 may include circuits for driving first and/or second sub-chips CH1 and CH2 or storing electrical signals generated by the first and/or second sub-chips CH1 and CH2.

Referring to FIG. 9, an antireflection structure AL may be disposed on the rear side 1b of the first substrate 1. The antireflection structure AL may include a first insulation layer A1, a conductive film A2, a second insulation layer A3, and a third insulation layer A4 that are sequentially stacked. The first insulation layer A1, the second insulation layer A3, and the third insulation layer A4 may include or may be formed of different materials. In an embodiment, the first insulation layer A1 may include or may be formed of aluminum oxide, the second insulation layer A3 may include or may be formed of silicon oxide, and the third insulation layer A4 may include or may be formed of hafnium oxide. The conductive film A2 may have electrical conductivity and may include or may be formed of titanium oxide.

In the present specification, the first insulation layer A1 may be referred to as a first antireflection layer, the conductive film A2 may be referred to as a second antireflection layer, the second insulation layer A3 may be referred to as a third antireflection layer, and the third insulation layer A4 may be referred to as a fourth antireflection layer.

The first substrate 1 may have a first refractive index n1, the first insulation layer A1 may have a second refractive index n2, the conductive film A2 may have a third refractive index n3, and the second insulation layer A3 may have a fourth refractive index n4. A mean value {(n2+n3)/2} of the second refractive index n2 and the third refractive index n3 may be less than the first refractive index n1 and may be greater than the fourth refractive index n4. The first refractive index n1 may be 4.0 to 4.4. The second refractive index n2 may be 2.0 to 3.0. The third refractive index n3 may be 2.2 to 2.8. The fourth refractive index n4 may be 1.0 to 1.9.

The first insulation layer A1 may have a first thickness T1, the conductive film A2 may have a second thickness T2, the second insulation layer A3 may have a third thickness T3, and the third insulation layer A4 may have a fourth thickness T4. Here, the second thickness T2 may be greater than each of the first thickness T1 and the fourth thickness T4, and may be less than the third thickness T3. The first thickness T1 may be 10Å to 100Å. The second thickness T2 may be 100Å to 600Å. The third thickness T3 may be 600Å to 900Å. The fourth thickness T4 may be 20Å to 200Å.

According to a relationship of the refractive indexes and/or a relationship of the thicknesses, light input to a micro lens ML may be refracted and pass through a multilayered structure of the antireflective structure AL and may be input to the photoelectric converter PD. Hence, the image sensor 503 with clear image quality may be provided by increasing the light receiving rate.

The antireflective structure AL of the image sensor 503 may include a conductive film A2 made of titanium oxide (TiO₂), and the conductive film A2 made of titanium oxide may generally reduce reflectance of light of all colors, and may particularly further reduce the reflectance of blue light. Hence, the quantum efficiency (QE) of the blue pixel may be increased.

The first insulation layer A1 may function as a negative fixed charge layer. Hence, the dark currents and the white spots may be reduced.

Further, a predetermined negative potential (voltage) may be applied to the conductive film A2 so that holes (h+), which are generated from light incident on the rear side 1b of the first substrate 1, may be accumulated around the rear side 1b of the first substrate 1. By this, the dark currents and the white spots may be further reduced.

The first optical black pattern 52p is disposed on the antireflection structure AL. The first optical black pattern 52p may be a single layer selected from a titanium layer, a titanium nitride layer, and a tungsten layer or a multilayer of at least one thereof.

A light blocking grid patterns 48a may be disposed in the antireflection structure AL in the pixel array region APS. Low-refraction grid patterns 50a may be respectively disposed on the light blocking grid patterns 48a. The light blocking grid pattern 48a and the low-refraction grid pattern 50a may overlap the first pixel separator DTI1 and may have a grid form when viewed in a plan view. The light blocking grid pattern 48a may include or may be formed of, for example, at least one of titanium and titanium nitride. The low-refraction grid pattern 50a may have the same thickness and the same organic material. The low-refraction grid pattern 50a may have a less refractive index than the color filters CF1 and CF2. For example, the low-refraction grid pattern 50a may have the refractive index of equal to or less than about 1.3. The light blocking grid pattern 48a and the low-refraction grid pattern 50a may prevent crosstalk among the adjacent sub-unit pixels UP.

The protective layer 56 may be conformally disposed on the first optical black pattern 52p, light blocking grid pattern 48a and low-refraction grid pattern 50a.

The color filters CF1 and CF2 may be disposed between the low-refraction grid patterns 50a on the protective layer 56 in the pixel array region APS. The color filters CF1 and CF2 may have one of the blue, green, and red colors. For example, the color filters CF1 and CF2 may include other colors such as cyan, magenta, and yellow. The color filters CF1 and CF2 may be arranged in a Bayer pattern in the image sensor according to the present embodiment. For example, the color filters CF1 and CF2 may be arranged in a 2x2 tetra pattern, a 3x3 nona pattern, or a 4x4 hexadeca pattern.

Micro lenses ML may be disposed on the color filters CF1 and CF2 in the pixel array region APS. Edges of the micro lenses ML may contact each other and may be connected with each other. The micro lenses ML may configure an array. The micro lenses ML may be referred to as a micro lens array.

The disposition of the active regions ACT, the transmission gate TG, the floating diffusion region FD, and the photoelectric converter PD disposed on the unit pixels UP, and the first shallow trench isolator STI1 and the floating diffusion region connector 19 may correspond to what has been described with reference to FIG. 5, FIG. 6A, FIG. 6B, and FIG. 6C.

The floating diffusion region connector of the image sensor according to the embodiment of FIG. 9 may be formed according to the method described with reference to FIG. 7A to FIG. 7D or the method described with reference to FIG. 8A to FIG. 8D.

When the floating diffusion region connector 19 is disposed in the shallow trench isolator STI as described above, the capacitive coupling formed between the wire disposed in the interlayer insulating layer may be reduced, and the freedom of disposing wires may be increased.

### <Reference Signs>

photoelectric converter PD
floating diffusion region FD
transmission gate TG
transmission transistor TX
reset transistor RX
selection transistor SX
source follower gate SF
source follower transistor DX
shallow trench isolator STI
floating diffusion region connector 19

## Claims

1. An image sensor (500, 503) comprising:
a first substrate (1) having a first side (1a) and a second side (1b) opposite each other, and including a pixel array region (APS) having a plurality of active regions (ACT) disposed at the first side (1a);
a shallow trench isolation structure (STI) disposed at the first side (1a) of the first substrate (1) and isolating each of the plurality of active regions (ACT);
a plurality of floating diffusion regions (FD) disposed at the plurality of active regions (ACT) of the first substrate (1); and
a floating diffusion region connector (19), of which at least part is buried in the shallow trench isolator (STI), connecting at least two of the floating diffusion regions (FD) .

2. The image sensor (500) of claim 1, further comprising:
a source follower transistor (DX) including a source follower gate electrode (SF) that is disposed on the first side (1a) of the first substrate (1),
wherein the source follower gate electrode (SF) is connected to the floating diffusion region connector (19).

3. The image sensor (500) of claim 2,
wherein the floating diffusion region connector (19) includes:
a stem portion (191) extending along a straight line extending in a first direction (D1);
a first branch portion (192) extending along a straight line extending in a second direction (D2) and connecting the stem portion (191) to the source follower gate electrode (SF); and
a second branch portion (193) extending along a straight line extending in the second direction (D2) and connected to a corresponding floating diffusion region of the plurality of floating diffusion regions (FD).

4. The image sensor (500) of claim 3,
wherein the plurality of floating diffusion regions (FD) include a first group (FD1) of floating diffusion regions (FD) and a second group (FD2) of floating diffusion regions (FD),
wherein the first group (FD1) of floating diffusion regions (FD) are spaced apart from the second group (FD2) of floating diffusion regions (FD) in the second direction (D2) and a portion of the shallow trench isolation structure (STI) is disposed between the first group (FD1) of floating diffusion regions (FD) and the second group (FD2) of floating diffusion regions (FD), and
wherein the stem portion (191) is disposed in a space between the first group (FD1) of floating diffusion regions (FD) and the second group (FD2) of floating diffusion regions (FD) when viewed in a plan view.

5. The image sensor (500) of claim 1, further comprises:
a plurality of transistors in a unit pixel (UP), wherein the plurality of transistors of the unit pixel include a plurality of transmission transistors (TX), a source follower transistor (DX), a reset transistor (RX), and a selection transistor (SX),
wherein the unit pixel (UP) includes a plurality of photoelectric converters (PD), and a plurality of first active regions (ACT1) and a plurality of second active regions (ACT2) among the plurality of active regions (ACT),
wherein at least one of the source follower transistor (DX), the reset transistor (RX), and the selection transistor (SX) is disposed at one or more of the plurality of first active regions (ACT1),
wherein the plurality of transmission transistors (TX) are disposed in the plurality of second active regions (ACT2), and
wherein each of the plurality of transmission transistors (TX) selectively connects a corresponding photoelectric converter among the plurality of photoelectric converters (PD) to a corresponding floating diffusion region among the plurality of floating diffusion regions (FD).

6. The image sensor (500) of claim 5,
wherein a source follower gate electrode (SF) of the source follower transistor (DX) overlaps two neighboring first active regions (ACT1) among the plurality of first active regions (ACT1) when viewed in a plan view.

7. The image sensor (500) of claim 5 or 6,
wherein each of the plurality of floating diffusion regions (FD) is disposed at a corresponding one of the plurality of second active regions (ACT2).

8. The image sensor (500) of any one of claims 2 to 4 and 6, further comprising:
a cover insulating layer (CI) formed on an upper surface of the floating diffusion region connector (19); and
a contact hole (CA) penetrating the cover insulating layer (CI) and exposing the upper surface of the floating diffusion region connector (19),
wherein the source follower gate electrode (SF) fills the contact hole (CA) and contacts the upper surface of the floating diffusion region connector (19),
wherein the shallow trench isolation structure (STI) includes a groove (GR) at the upper surface of the shallow trench isolation structure (STI),
wherein the cover insulating layer (CI) and the floating diffusion region connector (19) fills the groove (GR), and
wherein the floating diffusion region connector (19) fills a lower portion of the groove (GR) and the cover insulating layer (CI) fills an upper portion of the groove (GR).

9. The image sensor (500) of any one of claims 1 to 8, further comprising:
a second substrate (SB2) disposed on the first side (1a) of the first substrate (1) and a peripheral transistor (PTR) disposed on the second substrate (SB2).

10. The image sensor (500) of claim 9, further comprising:
a plurality of wires (15, 217, 317) and a plurality of interlayer insulating layers (IL1, IL2) disposed between the first substrate (1) and the second substrate (SB2).

11. The image sensor (503) of claim 1, further comprising:
a second substrate (SB2) and a third substrate (SB3) disposed on the first side (1a) of the first substrate (1);
a first wire (15) and a first interlayer insulating layer (IL1) disposed between the first substrate (1) and the second substrate (SB2);
a second wire (217) and a second interlayer insulating layer (IL2) disposed between the second substrate (SB2) and the third substrate (SB3); and
a third wire (317) and a third interlayer insulating layer (IL3) disposed on the third substrate (SB3).

12. The image sensor (503) of claim 11,
wherein the second substrate (SB2), the first wire (15), and the second wire (217) form at least one of a source follower transistor (DX), a selection transistor (SX), and a reset transistor (RX), and
wherein the third substrate (SB3) and the third wire (317) form a peripheral transistor (PTR).

13. The image sensor (500, 503) of any one of claims 1 to 12,
wherein the floating diffusion region connector (19) connects eight of the floating diffusion regions (FD).

14. The image sensor (500, 503) of any one of claims 1 to 13,
wherein the floating diffusion region connector (19) includes polysilicon doped with N-type impurities or silicon germanium doped with N-type impurities.

15. The image sensor (500, 503) of any one of claims 1 to 14,
wherein the floating diffusion region connector (19) includes metal.
